(19) Europäisches Patentamt
European Patent Office
Office européen des brevets

(11) Veröffentlichungsnummer: **0 186 156**
**A2**

(12) # EUROPÄISCHE PATENTANMELDUNG

(21) Anmeldenummer: 85116339.4

(22) Anmeldetag: 20.12.85

(51) Int. Cl.[4]: G 03 F 7/08

(30) Priorität: 27.12.84 US 686778

(43) Veröffentlichungstag der Anmeldung: 02.07.86 Patentblatt 86/27

(84) Benannte Vertragsstaaten: DE FR GB IT

(71) Anmelder: AMERICAN HOECHST CORPORATION
Route 202-206 North
Somerville, N.J. 08876(US)

(72) Erfinder: Walls, John E.
19 Bowlby Street
Hampton, N.J. 08801(US)

(72) Erfinder: Liu, Shuchen
59 North Slope
Clinton, N.J. 08809(US)

(74) Vertreter: Euler, Kurt Emil, Dr. et al,
KALLE Niederlassung der Hoechst AG Rheingaustrasse
190 Postfach 3540
D-6200 Wiesbaden 1(DE)

(54) **Lichtempfindliches Gemisch auf Basis von Diazoniumsalz-Kondensationsprodukten.**

(57) Durch Beschichten eines geeigneten Trägers mit einer lichtempfindlichen Schicht, in der zwei lichtempfindliche Diazoniumsalz-Polykondensationsprodukte und ein Bindemittelgemisch aus einem Polyvinylacetat und einem Styrol/Maleinsäurehalbester-Copolymeren enthalten sind, wird ein negativ arbeitendes licht-empfindliches Aufzeichnungsmaterial mit höherer Lichtempfindlichkeit erhalten. Nach bildmäßiger Belichtung des Aufzeichnungsmaterials mittels aktinischer Strahlung durch eine geeingnete Maske lassen sich die unbelichteten Stellen mit einem wäßrigalkalischen Entwickler entfernen.

EP 0 186 156 A2

0186156

AMERICAN HOECHST CORPORATION
Somerville, N.J. 08876/USA



# Lichtempfindliches Gemisch auf Basis von Diazoniumsalz-Kondensationsprodukten

Die vorliegende Erfindung betrifft ein lichtempfindliches Gemisch für die Herstellung von Flachdruckplatten, die in wäßrigen Entwicklern entwickelbar sind.

Aus der EP-A 135 026 ist ein lichtempfindliches Gemisch der genannten Gattung bekannt, das ein Diazoniumsalz-Polykondensationsprodukt, ein Styrol/Maleinsäurehalbester-Copolymeres und ein Vinylacetatpolymerisat enthält. Die Lichtempfindlichkeit der damit erhaltenen Flachdruckplatten ist für manche Zwecke nicht ausreichend, auch wäre eine Erhöhung der Druckauflage wünschenswert.

Aufgabe der Erfindung war es, ein lichtempfindliches Gemisch mit höherer Lichtempfindlichkeit vorzuschlagen, das ferner Druckformen mit erhöhter Druckauflage liefert.

Erfindungsgemäß wird ein hochlichtempfindliches Gemisch vorgeschlagen, das nach bildmäßiger Belichtung mit aktinischer Strahlung mit Hilfe eines im wesentlichen wäßrigen Entwicklers entwickelt werden kann. Das lichtempfindliche Gemisch enthält zwei negativ arbeitende lichtempfindliche Diazoniumsalzpolykondensations-

AMERICAN HOECHST CORPORATION
Somerville, N.J. 08876/USA



produkte und ein Bindemittelgemisch aus einem Polyvinylacetat und einem Styrol/Maleinsäurehalbestercopolymeren.

Der Ausdruck "im wesentlichen wäßriger Entwickler" bezeichnet wäßrige Lösungen von Salzen und Netzmitteln und weniger als 10 % an organischen Lösemitteln. Bevorzugt enthält der Entwickler weniger als 5 %, insbesondere weniger als 2 %, und besonders bevorzugt kein organisches Lösemittel.

Bei der ersten Diazoniumverbindung (Typ 1) handelt es sich um ein lichtempfindliches, im wesentlichen lineares, polymeres Diazoniumsalz-Kondensationsprodukt aus wiederkehrenden Einheiten der allgemeinen Typen

$$[E^+X^-] \quad \text{und} \quad [Q]$$

wobei $E^+X^-$ ein Rest der Verbindung der allgemeinen Formel

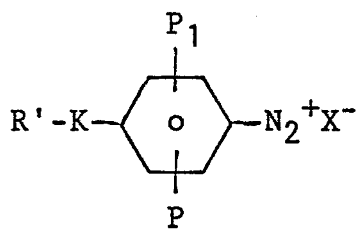

ist, in der

K -NH-, -S-, -O-, $-CH_2-$ oder eine Einfachbindung
R' ein Phenylrest oder ein durch Alkylgruppen mit 1 bis 4 C-Atomen substituierter Phenylrest ist,

AMERICAN HOECHST CORPORATION
Somerville, N.J. 08876/USA



| | |
|---|---|
| P und $P_1$ | gleich oder verschieden sind und Alkyl- oder Alkoxygruppen mit 1 bis 4 C-Atomen oder Wasserstoffatome bedeuten, |
| $X^-$ | das Anion des Diazoniumsalzes ist und |
| Q | der Rest eines Oligomeren der Formel |

$$R{-}M{-}({-}Y{-}\overset{\overset{T}{|}}{M})_m{-}R$$

ist, in der

| | |
|---|---|
| R | $-CH_2OH$, $-C(OH)(CH_3)_2$, $-CH_2O(CH_2)_nCH_3$, $-CH_2OOCCH_3$, $-CH_2Cl$ oder $-CH_2Br$ ist, |
| n | 0 oder eine ganze Zahl von 1 bis 3 ist, |
| M | den Rest eines aromatischen Kohlenwasserstoffs, Diarylethers, Diarylsulfids, Diarylsulfons, Diarylamins, Diarylketons oder Diaryldiketons bedeutet, |
| m | eine Zahl von 1 bis 6 ist, |
| Y | $CH_2$ oder $CH_2$-O-$CH_2$ ist, und |
| T | ein Rest R ist, wenn Y $CH_2$ bedeutet, und ein Wasserstoffatom ist, wenn Y $CH_2$-O-$CH_2$ bedeutet. |

Die beschriebene Diazoniumverbindung wird in einem zweistufigen Verfahren hergestellt. Dabei wird im wesentlichen zunächst eine vorkondensierte oligomere Komponente "Q" hergestellt und diese dann mit einem Rest "$E^+X^-$" umgesetzt, wobei das Verhältnis von "M" zu "$E^+X^-$" mindestens 2:1 beträgt. Wird diese Diazoniumverbindung allein auf einen geeigneten Träger aufgetragen, wird sie bei

AMERICAN HOECHST CORPORATION
Somerville, N.J. 08876/USA



Belichtung mittels einer geeigneten Lichtquelle mit einer Energie von etwa 4 mJ/cm² praktisch unlöslich.

Der Abstand zwischen den einzelnen Diazoniumgruppen in der polymeren Diazoniumverbindung beträgt mindestens 0,5 nm. Die Verbindung hat ein durchschnittliches Molekulargewicht bis zu etwa 60.000.

Eine eingehende Beschreibung dieser Klasse von Diazoniumverbindungen ist in der US-A 4,436,804 enthalten.

Die zweite Diazoniumverbindung (Typ 2) ist ein Kondensationsprodukt einer aromatischen Diazoniumverbindung aus wiederkehrenden Einheiten der allgemeinen Typen $A-N_2X$ und B, wobei $A-N_2X$ der Rest einer Verbindung einer der allgemeinen Formeln

$(R_1-R_3-)_p\ R_2-N_2X$ und 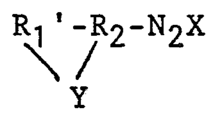

ist, in denen

$R_1$ eine substituierte oder unsubstituierte Phenyl- oder Naphthylgruppe ist;

$R_1'$ eine substituierte oder unsubstituierte Phenylen- oder Naphthylengruppe ist,

$R_2$ eine substituierte oder unsubstituierte Phenylengruppe ist,

AMERICAN HOECHST CORPORATION
Somerville, N.J. 08876/USA



$R_3$ eine Einfachbindung oder einer der Reste

$-(CH_2)_q-NR_4-$,

$-O-(CH_2)_r-NR_4-$,

$-S-(CH_2)_r-NR_4-$,

$-S-CH_2-CO-NR_4-$,

$-O-R_5-O-$,

-O-,

-S- oder

$-CO-NR_4-$

wobei
q 0 oder eine Zahl von 1 bis 5,
r eine Zahl von 2 bis 5,
$R_4$ Wasserstoff, eine Alkylgruppe mit 1 bis 5 C-Atomen, eine Aralkylgruppe mit 7 bis 12 C-Atomen oder eine Arylgruppe mit 6 bis 12 C-Atomen,
$R_5$ eine Arylengruppe mit 6 bis 12 C-Atomen,

Y -NH- oder -O-,
X das Anion des Diazoniumsalzes,
p eine Zahl von 1 bis 3 und
B der Rest eines von Diazoniumgruppen freien aromatischen Amins, eines Phenols, Thiophenols, Phenylethers, aromatischen Thioethers,

AMERICAN HOECHST CORPORATION
Somerville, N.J. 08876/USA



einer aromatischen heterocyclischen Verbindung eines aromatischen Kohlenwasserstoffs oder eines organischen Säureamids ist, wobei das Polykondensationsprodukt im Durchschnitt etwa 0,1 bis 50 Einheiten B pro Einheit $A-N_2X$ enthält.

Diese Klasse von Diazoverbindungen ist in der US-A 3,849,392 ausführlicher beschrieben.

Diese Polykondensationsprodukte werden durch das Umsetzen einer Diazoniumverbindung der allgemeinen Formel $A-N_2X$ mit einer Verbindung der allgemeinen Formel

$$E(-CHR_a-OR_b)_m$$

in einem stark sauren Medium erhalten,

wobei

E der Rest der durch Abspalten von m H-Atomen von einer Verbindung des bereits beschriebenen Typs B erhalten wird,

$R_a$ ein Wasserstoffatom oder Phenylrest ist,

$R_b$ ein Wasserstoffatom, einen Alkylrest der Formel $C_nH_{2n+1}$, einen Acylrest der Formel $C_nH_{2n+1}CO-$, worin n 0 oder eine Zahl von 1 bis 3 ist, oder eine Phenylgruppe bedeutet, und

m eine Zahl von 1 bis 10 ist.

AMERICAN HOECHST CORPORATION
Somerville, N.J. 08876/USA



Zur Herstellung des lichtempfindlichen Aufzeichnungsmaterials wird ein blattförmiges Trägermaterial verwendet. Dies kann beispielsweise Aluminium oder eine Aluminiumlegierung sein, insbesondere werden Aluminiumlegierungen gewählt, die speziell für die Herstellung von Flachdruckplatten geeignet sind, wie Alcoa 3003 und Alcoa 1100. Der Träger wird gegebenenfalls mit Hilfe der bekannten üblichen Aufrauh- und/oder Ätz- und/oder anodischen Oxydationsverfahren vorbehandelt und gegebenenfalls außerdem mit einem Mittel zur Verbesserung der Hydrophilie, z.B. Polyvinylphosphonsäure, behandelt. Anschließend wird der Träger mit dem lichtempfindlichen Belichtungsgemisch beschichtet.

Das lichtempfindliche Material wird dann durch eine Maske oder eine Transparentvorlage belichtet und in einer anschließenden Entwicklung der nicht belichtete Anteil der lichtempfindlichen Schicht von der belichteten Platte entfernt.

Das lichtempfindliche Gemisch enthält Diazoniumsalzkondensationsprodukte aus den zwei vorstehend beschriebenen Klassen, ein Polyvinylacetat und ein Styrol-Maleinsäurehalbester-Copolymeres. Das Gemisch kann ferner andere übliche Bestandteile, z.B. Farbmittel, stabilisierend wirkende Säuren und Belichtungsindikatoren enthalten.

Das am besten geeignete Diazoniumsalz-Kondensationsprodukt des Typs 1 ist das in zwei Stufen hergestellte

AMERICAN HOECHST CORPORATION
Somerville, N.J. 08876/USA



Kondensationsprodukt des Homokondensats aus 4,4'-Bis-methoxymethyl-diphenylether mit 3-Methoxy-diphenylamin-4-diazoniumsulfat, ausgefällt als Mesitylensulfonat. Es ist in der US-A 4,436,804 ausführlich beschrieben.

Ein besonders gut geeignetes Diazoniumsalz-Kondensationsprodukt des Typs 2 ist das Polykondensationsprodukt aus 3-Methoxy-diphenylamin-4-diazoniumsulfat und 4,4'-Bis-methoxymethyl-diphenylether, ausgefällt als Mesitylensulfonat. Es ist ausführlich beschrieben in der US-A 3,849,392.

Das für die praktische Durchführung dieser Erfindung geeignete Polyvinylacetat hat ein mittleres Molekulargewicht im Bereich von etwa 100.000 bis 800.000.

Vorzugsweise beträgt das mittlere Molekulargewicht maximal etwa 700.000. Am vorteilhaftesten liegt das mittlere Molekulargewicht im Bereicht von etwa 100.000 bis 380.000. Beispiele für erfindungsgemäß geeignete Polyvinylacetate sind z. B. Mowilith(R) 25, 30, 50 und 60, Herst. Hoechst AG, Frankfurt/Main.

Das erfindungsgemäß eingesetzte Styrol/Maleinsäurepartialester-Copolymere entspricht der allgemeinen Formel

AMERICAN HOECHST CORPORATION
Somerville, N.J. 08876/USA



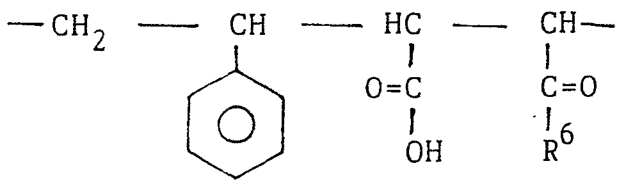

wobei $R^6$ der Rest eines niederen aliphatischen Alkohols mit 1 bis etwa 5 Kohlenstoffatomen ist. Das Verhältnis Styrol : Maleinsäurehalbester im Copolymeren beträgt im allgemeinen 1 : 1 oder darüber. Das mittlere Molekulargewicht des Copolymeren beträgt höchstens 50.000 und liegt zumeist unter 50.000. Das Copolymere hat vorzugsweise ein mittleres Molekulargewicht von etwa 10.000 bis 50.000. Ein erfindungsgemäß besonders bevorzugtes Copolymeres ist Scripset(R) 540 (Hersteller Monsanto) mit einem ungefähren mittleren Molekulargewicht von 20.000.

Erfindungsgemäß sind zum Beispiel die folgenden Säuren als Stabilisatoren geeignet: Phosphorsäure, Citronensäure, Weinsäure und p-Toluolsulfonsäure.

Als Belichtungsindikatoren eignen sich z.B. p-Phenylazodiphenylamin, die Farbstoffe Calcozin, Fuchsin, Kristallviolett und Methylenblau.

AMERICAN HOECHST CORPORATION
Somerville, N.J. 08876/USA



In dem lichtempfindlichen Kopiermaterial nach der Erfindung können als Farbmittel z.B. Farbstoffe, wie Acetosolfeuerrot 3 GLS, Sandolan-Eosin E-G, Acetosolgrün BLS, Genacrylblau 3G, Sandolan-Cyanin N-6B, Sandoplastblau R, Atlantic Alizarine Milling Blue FFR 200, Neozaponfeuerrot BL, Erythrosin, Methylenblau IaD Extra, Viktoriareinblau FGA und Pigmente, wie Grüngoldpigment und Sonnenechtviolett, verwendet werden.

Der Gesamtanteil der Diazoniumsalz-Kondensationsprodukte in der Beschichtungslösung beträgt im allgemeinen etwa 20 bis 50 Gew.-%, bezogen auf die festen Bestandteile. Vorteilhaft liegt ihr Anteil bei etwa 25 bis 45 Gew.-% und insbesondere bei etwa 30 bis 40 Gew.-%.

Das Verhältnis der Diazoverbindung von Typ 1 zur Diazoverbindung von Typ 2 beträgt bevorzugt 1:0,95 bis 1:1,45, insbesondere 1:1,10 bis 1:1,35 und ganz besonders bevorzugt 1:1,20 bis 1:1,30.

Der Gehalt an Polyvinylacetat in der Beschichtungslösung beträgt im allgemeinen etwa 8 bis 33 Gew.-%, bezogen auf die festen Bestandteile; vorteilhafter beträgt der Gehalt etwa 12 bis 28 Gew.-%, insbesondere etwa 18 bis 23 Gew.-%.

Der Anteil des Styrol/Maleinsäurehalbester-Copolymeren in der Beschichtungslösung, bezogen auf die festen Bestandteile, ist wie folgt: Im allgemeinen etwa

AMERICAN HOECHST CORPORATION
Somerville, N.J. 08876/USA



25 bis 55 Gew.-%, vorteilhaft etwa 32 bis 48 Gew.-% und insbesondere etwa 37 bis 43 Gew.-%.

Die gegebenenfalls verwendete stabilisierende Säure ist in einer Menge von etwa 1,5 bis 4,5 Gew.-%, bezogen auf die festen Bestandteile, vorteilhaft in einer Menge von 2,0 bis 4,0 Gew.-% und insbesondere in einer Menge von etwa 2,5 bis 3,5 Gew.-% vorhanden.

Der gegebenenfalls verwendete Belichtungsindikator ist in folgenden Anteilen in der Beschichtungslösung enthalten: Im allgemeinen etwa 0,05 bis 0,35 Gew.-%, vorteilhaft etwa 0,10 bis 0,30 Gew.-% und insbesondere etwa 0,15 bis 0,25 Gew.-%, jeweils bezogen auf die festen Bestandteile.

Falls ein Farbmittel, d.h. ein Farbstoff, Farbpigment oder dgl., verwendet wird, so ist dieses in einem Anteil von etwa 0,25 bis 0,55 Gew.-%, vorteilhaft von etwa 0,30 bis 0,50 Gew.-% und insbesondere von etwa 0,35 bis 0,45 Gew.-%, jeweils bezogen auf die festen Bestandteile, in der Beschichtungslösung enthalten.

Geeignete Lösemittel für die Bestandteile der erfindungsgemäßen Beschichtungsmasse sind z.B. Ethylenglykolether, Butyrolacton, Alkohole, z.B. Ethanol und n-Propanol; und Ketone, z.B. Methylethylketon.

Zu den geeigneten Trägermaterialien, die für die Herstellung des erfindungsgemäßen lichtempfindlichen

AMERICAN HOECHST CORPORATION
Somerville, N.J. 08876/USA



Aufzeichnungsmaterials verwendet werden können, zählen u.a. transparente Folien, Aluminiumlegierungen, Silizium und ähnliche bekannte Materialien.

Bei der Herstellung von Flachdruckplatten wird ein Aluminiumträger zunächst vorzugsweise nach bewährten Verfahren aufgerauht, z.B. durch Drahtbürsten, durch Bürsten mit einer Aufschlämmung von feinteiligen Stoffen oder auf elektrochemischem Wege, z.B. in einem Salzsäureelektrolyten. Die aufgerauhte Platte kann dann auf bekannte Weise, zum Beispiel in Schwefel- oder Phosphorsäure, anodisch oxydiert werden. Danach wird die aufgerauhte und anodisch oxydierte Oberfläche gegebenenfalls hydrophiliert, zum Beispiel durch eine Behandlung mit Polyvinylphosphonsäure, Natriumsilikat oder dergl. Die so vorbereitete Platte wird anschließend mit dem erfindungsgemäßen Gemisch beschichtet, getrocknet, durch eine geeignete Maske mit aktinischer Strahlung belichtet und mit einem wäßrigen Entwickler entwickelt. Als Entwickler eignet sich beispielsweise eine wäßrig-alkalische Lösung mit einem Gehalt an:

a) einem Natrium-, Kalium- oder Lithiumsalz des Monooctyl-, Monodecyl- oder Monododecylsulfats,
b) einem Natrium-, Lithium-, Kalium- oder Ammoniummetasilikat,
c) einem Lithium-, Kalium-, Natrium- oder Ammoniumborat,

AMERICAN HOECHST CORPORATION
Somerville, N.J. 08876/USA



d) einer aliphatischen Dicarbonsäure mit 2 bis 6 Kohlenstoffatomen oder deren Natrium-, Kalium- oder Ammoniumsalz und/oder

e) Di- und/oder Trinatrium- oder -kaliumphosphat.

Die Erfindung wird anhand der folgenden Beispiele näher erläutert:

## Beispiel 1

Es wird eine Beschichtungslösung der folgenden Zusammensetzung hergestellt:

| | | |
|---|---|---|
| 86,035 | Gew.-% | Ethylenglykolmonomethylether, |
| 0,445 | Gew.-% | Phosphorsäure (85%ig), |
| 2,669 | Gew.-% | Polyvinylacetat, MG etwa 400.000 (Mowilith 60), |
| 5,562 | Gew.-% | Styrol/Maleinsäurehalbester-Copolymeres, MG etwa 20.000 (Scripset(R) 540), |
| 0,033 | Gew.-% | 4-Phenylazodiphenylamin, |
| 0,250 | Gew.-% | Acetosolfeuerrot |
| 2,225 | Gew.-% | des Kondensationsproduktes 1, erhalten durch Kondensation von 1 mol des Homokondensationsprodukts aus 2,5 mol 4,4'-Bis-methoxymethyl-diphenylether mit 1 mol 3-Methoxy-diphenylamin-4-diazoniumsulfat, isoliert als Mesitylensulfonat, |

AMERICAN HOECHST CORPORATION
Somerville, N.J. 08876/USA



| | | |
|---|---|---|
| 2,781 | Gew.-% | des Kondensationsprodukts 2, erhalten aus 1 mol 3-Methoxy-diphenylamin-4-diazoniumsulfat und 1 mol 4,4'-Bis-methoxymethyl-diphenylether, isoliert als Mesitylensulfonat |

Die obengenannten Bestandteile werden unter kräftigem Rühren nacheinander in 450 g Ethylenglykolmonoethylether gegeben. Nach Auflösung aller Bestandteile wird die Lösung filtriert und mit 70 U/min auf eine durch Bürsten mit einer Schleifmittelsuspension aufgerauhte und hydrophilierte Aluminiumplatte aufgeschleudert. Nach dem Trocknen wird die Platte in einem Berkey/Ascor-Belichtungsgerät durch eine Negativvorlage mit 115 mJ/cm² belichtet, so daß auf einem Stufenkeil mit 21-Stufen eine vollgedeckte Stufe 6 erhalten wird. Die belichtete Platte wird mit einem wäßrig-alkalischen Entwickler der folgenden Zusammensetzung entwickelt:

| | | |
|---|---|---|
| 91,7 | Gew.-% | $H_2O$ |
| 2,5 | Gew.-% | Natriumoctylsulfat |
| 0,1 | Gew.-% | Natriummetasilikat |
| 1,5 | Gew.-% | Dinatriumhydrogenphosphat |
| 1,5 | Gew.-% | Trinatriumphosphat |
| 1,7 | Gew.-% | Kaliumoxalat |
| 1,0 | Gew.-% | Kaliumtetraborat |

Dabei werden die nichtbelichteten Teile der Beschichtung entfernt, und die belichteten Teile verbleiben als Bild auf der Platte. Die Platte wird mit einer wäßrigen Lö-

AMERICAN HOECHST CORPORATION
Somerville, N.J. 08876/USA



sung von 10 % hydrolysierter Tapiokastärke und 0,5 % Phosphorsäure nachbehandelt. Die so hergestellte Platte wird in eine Bogenoffsetmaschine eingespannt und liefert unter normalen Druckbedingungen 45.000 Kopien in guter Qualität.

Beispiel 2 (Vergleichsbeispiel)

Es wird nach den Angaben von Beispiel 1 verfahren, doch wird in diesem Fall nur das Kondensationsprodukt vom Typ 2 in einer Menge von 5,006 Gew.-% verwendet; das entspricht der Summe der Kondensationsprodukte der Typen 1 und 2 in Beispiel 1. Um auf einem Halbtonstufenkeil mit 21 Stufen eine vollgedeckte Stufe 6 zu erreichen, wird eine Belichtungsenergie von 240 $mJ/cm^2$ benötigt. Die fertige Platte wird in eine Bogenoffsetmaschine eingespannt und liefert unter normalen Druckbedingungen 30.000 gute Drucke.

Beispiel 3 (Vergleichsbeispiel)

Es wird nach den Angaben von Beispiel 1 verfahren, doch wird in diesem Fall nur die Diazoverbindung vom Typ 1 in einer Menge von 5,006 Gew.-% verwendet. Um auf dem Stufenkeil eine vollgedeckte Stufe 6 zu erhalten, wird eine Belichtungsenergie von 180 $mJ/cm^2$ benötigt. Die fertige Platte wird in eine Bogenoffsetmaschine eingespannt und liefert unter normalen Druckbedingungen 8.000 gute Drucke.

AMERICAN HOECHST CORPORATION
Somerville, N.J. 08876/USA



Beispiel 4

Es wird nach den Angaben von Beispiel 1 gearbeitet, jedoch wird hier die beschriebene Beschichtungslösung auf eine elektrolytisch aufgerauhte, anodisch oxydierte und hydrophilierte Aluminiumplatte aufgebracht. Die fertige Platte wird in eine Bogenoffsetmaschine eingespannt und liefert unter normalen Druckbedingungen 265.000 Kopien in guter Qualität.

Beispiel 5 (Vergleichsbeispiel)

Es wird nach den Angaben von Beispiel 2 gearbeitet, jedoch wird hier die beschriebene Beschichtungslösung auf eine elektrolytisch aufgerauhte, anodisch oxydierte und hydrophilierte Aluminiumoberfläche aufgebracht. Die fertige Platte wird in eine Bogenoffsetmaschine eingespannt und liefert unter normalen Druckbedingungen 205.000 Kopien in guter Qualität.

Beispiel 6 (Vergleichsbeispiel)

Es wird nach den Angaben von Beispiel 3 gearbeitet, jedoch wird hier die beschriebene Beschichtungslösung auf eine elektrolytisch aufgerauhte, anodisch oxydierte und hydrophilierte Aluminiumoberfläche aufgebracht. Die fertige Platte wird in eine Bogenoffsetmaschine eingespannt und liefert unter normalen Druckbedingungen 40.000 Kopien in guter Qualität.

AMERICAN HOECHST CORPORATION
Somerville, N.J. 08876/USA



## Patentansprüche

1. Lichtempfindliches Gemisch für die Herstellung von Flachdruckplatten, das als wesentliche Bestandteile ein Polyvinylacetat mit einem mittleren Molekulargewicht im Bereich von 100.000 bis 800.000, ein Styrol/Maleinsäurehalbester-Copolymeres mit einem mittleren Molekulargewicht von nicht mehr als 50.000 und ein Diazoniumsalz-Polykondensationsprodukt vom Typ 2 aus wiederkehrenden Einheiten der allgemeinen Typen $A-N_2X$ und B enthält, wobei $A-N_2X$ der Rest einer Verbindung einer der allgemeinen Formeln

$(R_1-R_3-)_p\ R_2-N_2X$ und 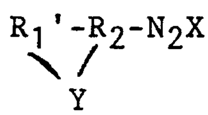

ist, in denen

| | |
|---|---|
| $R_1$ | eine substituierte oder unsubstituierte Phenyl- oder Naphthylgruppe ist; |
| $R_1'$ | eine substituierte oder unsubstituierte Phenylen- oder Naphthylengruppe ist, |
| $R_2$ | eine substituierte oder unsubstituierte Phenylengruppe ist, |
| $R_3$ | eine Einfachbindung oder einer der Reste |

$-(CH_2)_q-NR_4-$,

$-O-(CH_2)_r-NR_4-$,

$-S-(CH_2)_r-NR_4-$,

AMERICAN HOECHST CORPORATION
Somerville, N.J. 08876/USA



$-S-CH_2-CO-NR_4-$,

$-O-R_5-O-$,

-O-,

-S- oder

$-CO-NR_4-$ ist,

wobei
q 0 oder eine Zahl von 1 bis 5,
r eine Zahl von 2 bis 5,
$R_4$ Wasserstoff, eine Alkylgruppe mit 1 bis 5 C-Atomen, eine Aralkylgruppe mit 7 bis 12 C-Atomen oder eine Arylgruppe mit 6 bis 12 C-Atomen,
$R_5$ eine Arylengruppe mit 6 bis 12 C-Atomen,

Y -NH- oder -O-,
X das Anion des Diazoniumsalzes,
p eine Zahl von 1 bis 3 und
B der Rest eines von Diazoniumgruppen freien aromatischen Amins, eines Phenols, Thiophenols, Phenylethers, aromatischen Thioethers, einer aromatischen heterocyclischen Verbindung eines aromatischen Kohlenwasserstoffs oder eines organischen Säureamids ist, wobei das Polykondensationsprodukt im Durchschnitt etwa 0,1 bis 50 Einheiten B pro Einheit $A-N_2X$ enthält,

dadurch gekennzeichnet, daß das Gemisch ferner ein Diazoniumsalz-Polykondensationsprodukt vom Typ 1 aus wiederkehrenden Einheiten der allgemeinen Typen

AMERICAN HOECHST CORPORATION
Somerville, N.J. 08876/USA



$$[E^+X^-] \quad \text{und} \quad [Q]$$

enthält, wobei $E^+X^-$ ein Rest einer Verbindung der allgemeinen Formel

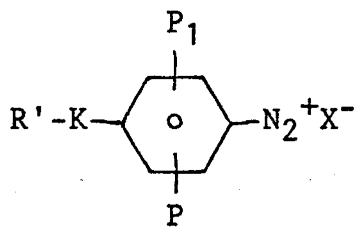

ist, in der

| | |
|---|---|
| K | $-NH-$, $-S-$, $-O-$, $-CH_2-$ oder eine Einfachbindung |
| R' | ein Phenylrest oder ein durch Alkylgruppen mit 1 bis 4 C-Atomen substituierter Phenylrest ist, |
| P und $P_1$ | gleich oder verschieden sind und Alkyl- oder Alkoxygruppen mit 1 bis 4 C-Atomen oder Wasserstoffatome bedeuten, |
| $X^-$ | das Anion des Diazoniumsalzes ist und |
| Q | der Rest eines Oligomeren der Formel |

$$R-M-(-Y-\overset{T}{\overset{|}{M}})_m-R$$

ist, in der

| | |
|---|---|
| R | $-CH_2OH$, $-C(OH)(CH_3)_2$, $-CH_2O(CH_2)_nCH_3$, $-CH_2OOCCH_3$, $-CH_2Cl$ oder $-CH_2Br$ ist, |

AMERICAN HOECHST CORPORATION
Somerville, N.J. 08876/USA



n 0 oder eine ganze Zahl von 1 bis 3 ist,

M der Rest eines aromatischen Kohlenwasserstoffs, eines Diarylethers, Diarylsulfids, Diarylsulfons, Diarylamins, Diarylketons oder Diaryldiketons bedeutet,

m eine Zahl von 1 bis 6 ist,

Y $CH_2$ oder $CH_2$-O-$CH_2$ ist, und

T ein Rest R ist, wenn Y $CH_2$ bedeutet, und ein Wasserstoffatom ist, wenn Y $CH_2$-O-$CH_2$ bedeutet, wobei das Verhältnis von M zu $E^+X^-$ mindestens 2:1 beträgt.

2. Gemisch nach Anspruch 1, dadurch gekennzeichnet, daß die Gesamtmenge an Diazoniumverbindungen 20 bis 50 %, bezogen auf das Gewicht des Gemisches, beträgt.

3. Gemisch nach Anspruch 1, dadurch gekennzeichnet, daß die Menge an Polyvinylacetat 8 bis 33 %, bezogen auf das Gewicht des Gemisches, beträgt.

4. Gemisch nach Anspruch 1, dadurch gekennzeichnet, daß die Menge an Styrol/Maleinsäurehalbester-Copolymerem etwa 25 bis 55 %, bezogen auf das Gewicht des Gemisches, beträgt.

5. Gemisch nach Anspruch 1, dadurch gekennzeichnet, daß das Molekulargewicht des Copolymeren im Bereich von etwa 10.000 bis 50.000 liegt.

AMERICAN HOECHST CORPORATION
Somerville, N.J. 08876/USA



6. Gemisch nach Anspruch 1, dadurch gekennzeichnet, daß das Verhältnis des Kondensationsprodukts vom Typ 1 zu dem Kondensationsprodukt vom Typ 2 im Bereich von 1:0,95 bis 1:1,45 liegt.

7. Lichtempfindliches Aufzeichnungsmaterial, das aus einem Träger und einer darauf aufgebrachten Schicht aus dem Gemisch nach Anspruch 1 besteht.

8. Aufzeichnungsmaterial nach Anspruch 7, dadurch gekennzeichnet, daß der Träger aus Aluminium oder einer Aluminiumlegierung besteht.